# EUROPEAN PATENT APPLICATION

(11) **EP 4 606 935 A1**
(43) Date of publication of application: **27.08.2025**
(21) Application number: 23879487.9
(22) Date of filing: 31.08.2023
(51) Int. Cl.: C30B 29/38, C30B 25/18, H01L 21/20, H01L 21/205

(54) **METHOD FOR MANUFACTURING NITRIDE SEMICONDUCTOR EPITAXIAL WAFER, AND COMPOSITE SUBSTRATE FOR NITRIDE SEMICONDUCTOR EPITAXIAL WAFER**

(30) Priority: 20.10.2022 JP 2022168075
(71) Applicant: Shin-Etsu Handotai Co., Ltd., Tokyo 100-0004 (JP)
(72) Inventor: TSUCHIYA Keitaro, Annaka-shi, Gunma 379-0196 (JP); KUBONO Ippei, Annaka-shi, Gunma 379-0196 (JP); HAGIMOTO Kazunori, Annaka-shi, Gunma 379-0196 (JP)
(74) Representative: Schicker, Silvia
(86) International application number: PCT/JP2023/031688
(87) International publication number: WO 2024/084836

(57) **Abstract**

The present invention is a method for manufacturing a nitride semiconductor epitaxial wafer that includes a composite substrate having a ceramic-containing substrate and a single crystal layer bonded onto the ceramic-containing substrate, and a nitride semiconductor layer epitaxially grown on the composite substrate, the method including the steps of providing the composite substrate including the ceramic-containing substrate having a coefficient of thermal expansion within ±10% of a coefficient of thermal expansion of the nitride semiconductor layer, and having a shape of -150 < Bow (µm) ≤ 40, Warp (µm) < 150 and Warp (µm) < 90 - Bow (µm), forming an intermediate layer configured to apply compressive stress to the nitride semiconductor layer on the single crystal layer of the composite substrate, and epitaxially growing the nitride semiconductor layer on the intermediate layer, in which the nitride semiconductor epitaxial wafer having a shape of Warp (µm) < 50 and |Bow (µm)| ≤ 40 is manufactured by adjusting a film thickness of the intermediate layer. This provides the method for manufacturing a nitride semiconductor epitaxial wafer having a small warp, no cracks, and no peeling.

## Description

### TECHNICAL FIELD

The present invention relates to a method for manufacturing a nitride semiconductor epitaxial wafer and a composite substrate for a nitride semiconductor epitaxial wafer.

### BACKGROUND ART

Nitride semiconductors, including GaN and AlN, can be used for producing high electron mobility transistors (HEMT) that use two-dimensional electron gas and are therefore expected to be applied to semiconductor devices for high frequencies. Furthermore, such nitrides are also piezoelectric materials that are excellent in mechanical properties and are also expected to be used for high-frequency filters for communication, sensors, energy harvesters, etc. Furthermore, in addition to applications for communications, micro-LEDs for displays are also being considered for production using nitride semiconductors, and larger diameters, higher quality, and lower costs are desired.

However, production of such nitride wafers is difficult, and growth by a common melt growth method, as in the case of silicon single crystal substrates, is difficult. In industrial applications, thin films obtained by vapor deposition on a sapphire, SiC, or Si substrate are used; however, the generation of deformation, cracking, and peeling of the substrates due to stress during growth are concerned, and growth conditions and device structures are limited.

In a device process, it is concerned that increased warp may cause substrates falling due to adsorption failure or a decreased yield due to exposure failure; therefore, it is desirable for the substrate warp to be Warp < 50 µm and |Bow| ≤ 40 µm.

On the other hand, when the cracks are generated, it is impossible to produce the devices at locations where the cracks are generated, resulting in decreasing yield. Furthermore, when a large number of cracks are generated or stress is applied, epitaxial layers peel off. When thin films on a surface unintentionally peel off, a concern arises that the process is contaminated and the yield is decreased.

For example, Patent Documents 1 and 2 disclose a technique to reduce warp by relaxing stress due to epitaxial growth using a buffer layer. However, in heteroepitaxial growth where GaN is grown on a Si substrate, distributions in film thicknesses and compositions may be generated, and this can lead to a decrease in an in-plane uniformity of characteristics.

On the other hand, Patent Document 3 discloses a technique to reduce stress caused by cooling after epitaxial growth by epitaxially growing GaN on substrates having a coefficient of thermal expansion that matches that of GaN. However, since Si and SiGe are used for single crystal layers where nitride semiconductors are grown, stress due to a difference in lattice constant is generated. Concerns arise that warp failures, cracks, and peeling of films may be generated due to stress caused by the difference in lattice constant.

### CITATION LIST

### PATENT LITERATURE

Patent Document 1: JP 5159858 B2
Patent Document 2: JP 2005-72561 A
Patent Document 3: JP 2020-505767 A

### SUMMARY OF INVENTION

### TECHNICAL PROBLEM

The present invention has been made to solve the above-described problem. An object of the present invention is to provide a method for manufacturing a nitride semiconductor epitaxial wafer having a small warp, no cracks, and no peeling, and a composite substrate for a nitride semiconductor epitaxial wafer used for this method. In particular, an object is to provide a method for manufacturing a group III nitride semiconductor epitaxial wafer suitable for micro-LEDs, high-frequency switches, power amplifiers, and GaN-based high-mobility transistors (HEMT) for power switching devices.

### SOLUTION TO PROBLEM

To achieve the object, the present invention provides a method for manufacturing a nitride semiconductor epitaxial wafer that comprises a composite substrate having a ceramic-containing substrate and a single crystal layer bonded onto the ceramic-containing substrate, and a nitride semiconductor layer epitaxially grown on the composite substrate, the method comprising the steps of:
providing the composite substrate comprising the ceramic-containing substrate having a coefficient of thermal expansion within ±10% of a coefficient of thermal expansion of the nitride semiconductor layer, and having a shape of -150 < Bow (µm) ≤ 40, Warp (µm) < 150 and Warp (µm) < 90 - Bow (µm);
forming an intermediate layer configured to apply compressive stress to the nitride semiconductor layer on the single crystal layer of the composite substrate; and
epitaxially growing the nitride semiconductor layer on the intermediate layer, wherein
the nitride semiconductor epitaxial wafer having a shape of Warp (µm) < 50 and |Bow (µm)| ≤ 40 is manufactured by adjusting a film thickness of the intermediate layer.

According to such a method for manufacturing a nitride semiconductor epitaxial wafer, the nitride semiconductor epitaxial wafer can be manufactured with a small warp without cracks or peeling.

In this case, the ceramic-containing substrate can have a heat-resistant support substrate having a ceramic core and an encapsulating layer covering the ceramic core, and a planarization layer provided on the heat-resistant support substrate.

According to such a method for manufacturing a nitride semiconductor epitaxial wafer, the nitride semiconductor epitaxial wafer can be more reliably manufactured with a small warp without cracks or peeling.

In this case, the ceramic core in which a polycrystalline AlN ceramic is a main component can be used.

According to such a method for manufacturing a nitride semiconductor epitaxial wafer, the nitride semiconductor epitaxial wafer can be more reliably manufactured with a small warp without cracks or peeling.

In this case, the encapsulating layer can be formed from a component represented by SiOₓN_{y} (where x = 0 to 2, y = 0 to 1.5, x + y > 0).

According to such a method for manufacturing a nitride semiconductor epitaxial wafer, the nitride semiconductor epitaxial wafer can be more reliably manufactured with a small warp without cracks or peeling.

In this case, the planarization layer can be formed from any of SiOₓN_{y} (where x = 0 to 2, y = 0 to 1.5, x + y > 0) and aluminum arsenide.

The single crystal layer can be formed from any of Si, SiGe, SiC, sapphire, GaN, AlGaN, and AlN.

The planarization layers and the single crystal layers described above can be used, thereby more reliably manufacturing the nitride semiconductor epitaxial wafer with a small warp without cracks or peeling.

In this case, the intermediate layer can be formed from a mixed crystal of AlN, InN, and GaN.

According to such a method for manufacturing a nitride semiconductor epitaxial wafer, the nitride semiconductor epitaxial wafer can be more reliably manufactured with a small warp without cracks or peeling.

To achieve the object, the present invention provides a composite substrate for a nitride semiconductor epitaxial wafer in which the composite substrate is used as an underlying substrate for epitaxially growing a nitride semiconductor layer, the composite substrate comprising:
a ceramic-containing substrate; and
a single crystal layer bonded onto the ceramic-containing substrate, wherein
the ceramic-containing substrate has a coefficient of thermal expansion within ±10% of a coefficient of thermal expansion of the nitride semiconductor layer, and has a shape of -150 < Bow (µm) ≤ 40, Warp (µm) < 150 and Warp (µm) < 90 - Bow (µm).

Such a composite substrate for a nitride semiconductor epitaxial wafer can be suitable as an underlying substrate of the nitride semiconductor epitaxial wafer with a small warp without cracks or peeling.

### ADVANTAGEOUS EFFECTS OF INVENTION

As described above, according to the inventive method for manufacturing a nitride semiconductor epitaxial wafer, the nitride semiconductor epitaxial wafer can be manufactured with a small warp without cracks or peeling. An inexpensive GaN epitaxial substrate with Warp < 50 µm and |Bow| ≤ 40 µm, without cracks or epitaxial layer peeling, can be obtained at a high yield. Moreover, it is possible to reduce the warp during growth, thereby improving in-plane uniformity of various characteristics.

Moreover, according to the inventive composite substrate for a nitride semiconductor epitaxial wafer, by using this substrate as the underlying substrate, the composite substrate can be used for manufacturing a nitride semiconductor epitaxial wafer with a small warp without cracks or peeling and the inexpensive GaN epitaxial substrate with Warp < 50 µm and |Bow| ≤ 40 µm, without cracks or epitaxial layer peeling can be provided. In addition, this enables the production of the GaN epitaxial substrate with improved in-plane uniformity of various characteristics.

### BRIEF DESCRIPTION OF DRAWINGS

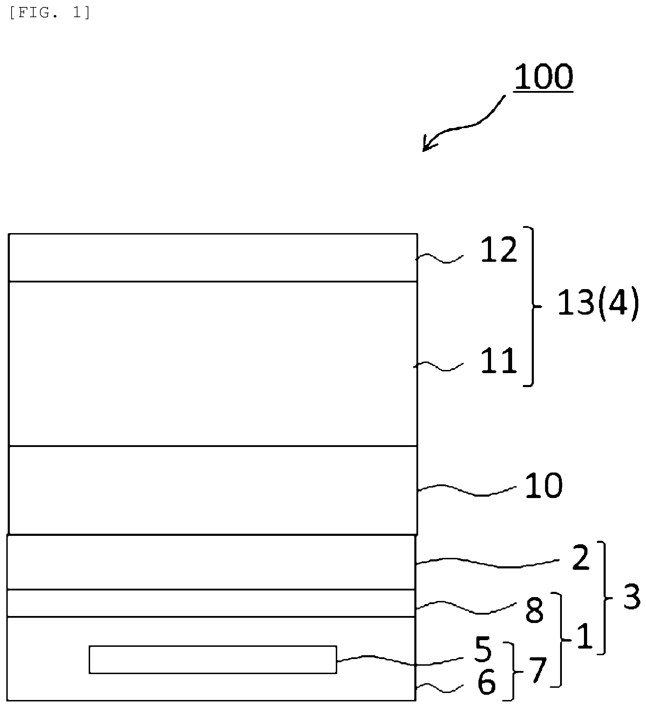

FIG. 1 is a cross-sectional view illustrating an example of a nitride semiconductor epitaxial wafer manufactured by a method for manufacturing a nitride semiconductor epitaxial wafer according to the present invention.

### DESCRIPTION OF EMBODIMENTS

Hereinafter, the present invention will be described in detail. However, the present invention is not limited thereto.

As described above, a method for manufacturing a nitride semiconductor epitaxial wafer with a small warp without cracks or peeling has been desired.

To solve the above problem, the present inventors have earnestly studied and found a method for manufacturing a nitride semiconductor epitaxial wafer that comprises a composite substrate having a ceramic-containing substrate and a single crystal layer bonded onto the ceramic-containing substrate, and a nitride semiconductor layer epitaxially grown on the composite substrate, the method including the steps of:
providing the composite substrate comprising the ceramic-containing substrate having a coefficient of thermal expansion within ±10% of a coefficient of thermal expansion of the nitride semiconductor layer, and having a shape of -150 < Bow (µm) ≤ 40, Warp (µm) < 150 and Warp (µm) < 90 - Bow (µm);
forming an intermediate layer configured to apply compressive stress to the nitride semiconductor layer on the single crystal layer of the composite substrate; and
epitaxially growing the nitride semiconductor layer on the intermediate layer, wherein
the nitride semiconductor epitaxial wafer having a shape of Warp (µm) < 50 and |Bow (µm)| ≤ 40 is manufactured by adjusting a film thickness of the intermediate layer, and thereby, the nitride semiconductor epitaxial wafer with a small warp without cracks or peeling can be provided. This finding has led to the completion of the present invention. Moreover, the present invention is a composite substrate for a nitride semiconductor epitaxial wafer in which the composite substrate is used as an underlying substrate for epitaxially growing a nitride semiconductor layer, the composite substrate including:
   a ceramic-containing substrate; and
   a single crystal layer bonded onto the ceramic-containing substrate, wherein
   the ceramic-containing substrate has a coefficient of thermal expansion within ±10% of a coefficient of thermal expansion of the nitride semiconductor layer, and has a shape of -150 < Bow (µm) ≤ 40, Warp (µm) < 150 and Warp (µm) < 90 - Bow (µm).

Hereinafter, the method for manufacturing a nitride semiconductor epitaxial wafer and the composite substrate for a nitride semiconductor epitaxial wafer according to the embodiment of the present invention will be described.

### (Nitride Semiconductor Epitaxial Wafer)

FIG. 1 is a cross-sectional view illustrating an example of the nitride semiconductor epitaxial wafer manufactured by the inventive method for manufacturing a nitride semiconductor epitaxial wafer.

As shown in FIG. 1, a nitride semiconductor epitaxial wafer 100 is configured to have a nitride semiconductor layer 4 stacked on a composite substrate 3.

As the nitride semiconductor layer 4, a device layer 13 is stacked on an intermediate layer 10.

The device layer 13 is, for example, formed by stacking an electron supply layer 12 on a gallium nitride layer 11 and forms the nitride semiconductor layer.

The composite substrate 3 is formed by bonding a single crystal layer 2 to a ceramic-containing substrate 1.

The ceramic-containing substrate 1 is formed by stacking a planarization layer 8 on a heat-resistant support substrate 7.

The heat-resistant support substrate 7 is formed by covering a ceramic core 5 with an encapsulating layer 6.

### (Ceramic Core 5)

As the ceramic core 5, it is possible to use aluminum nitride (AlN), silicon nitride (Si₃N₄), gallium nitride (GaN), boron nitride (BN), a mixture of these materials, or the like. From the viewpoint of the difference in a coefficient of thermal expansion and thermal conductivity, the ceramic core is preferably produced from ceramic containing AlN as a main component.

### (Encapsulating Layer 6)

The encapsulating layer 6 is a layer for preventing substances contained in the ceramic core 5 from leaking outside and is formed on the entire surface of the ceramic core 5 so as to enclose the ceramic core 5. The encapsulating layer 6 is produced from a composition represented by a composition formula of SiOₓN_{y} (where x = 0 to 2, y = 0 to 1.5, x + y > 0). The encapsulating layer 6 can be formed by a film formation method such as an MOCVD method, an atmospheric pressure CVD method, an LPCVD (low-pressure CVD) method, or a sputtering method. In particular, the use of the LPCVD method is preferable because a fine film can be formed, in addition, the coverage properties of the film are excellent.

### (Heat-Resistant Support Substrate 7)

The planarization layer 8, having a thickness of 0.2 µm to 3.0 µm, is stacked on the heat-resistant support substrate 7, including the ceramic core 5 and the encapsulating layer **6.** By growing the planarization layer 8, voids and unevenness of the heat-resistant support substrate 7 are filled so that the single crystal layer 2 can be easily bonded. The planarization layer 8 preferably contains any of silicon nitride, silicon oxynitride, and aluminum arsenide. The forming method is not limited to these methods, but the planarization layer 8 can be formed by plasma CVD, LPCVD, or low-pressure MOCVD.

Moreover, a conductive layer containing polysilicon may be formed depending on necessity. The conductive layer contains polysilicon and is stacked by the LPCVD process and the like and has a thickness of approximately 50 to 500 nm. This is a layer to provide conductivity and being doped with, for example, boron (B) or phosphorus (P) or the like. This conductive layer is provided depending on the necessity and may be omitted or may be formed on only one surface. The position where the film is formed is not limited to an inside of the encapsulating layer 6 (on the ceramic core 5 side) and may be formed on the outer side.

### (Single Crystal Layer 2)

The single crystal layer 2 can be, for example, a silicon single crystal layer. The silicon single crystal layer can be produced by peeling and transferring from a silicon single crystal. A method for peeling and transferring is not limited to a method described below, but the silicon single crystal layer can be produced by the steps of: providing a silicon single crystal; forming a fragile layer by implanting ions in the silicon single crystal; and bonding to the planarization layer 8 of the ceramic-containing substrate 1 to separate the single crystal layer 2. The ion implantation is not limited to the following elements, but H₂, Ar, He, etc., can be used, for example. In addition, the single crystal layer 2 only needs to be able to epitaxially grow a high-quality nitride semiconductor, and it is possible to use materials other than the silicon single crystal layer, such as SiGe, SiC, sapphire, GaN, AlGaN, and AlN, for example.

### (Intermediate Layer 10)

The intermediate layer 10 acts as a buffer layer inserted for improving crystallinity of the device layer 13 and controlling stress thereof. The intermediate layer 10 is desirably made of a nitride because it can be produced using the same equipment with the device layer 13. For example, the intermediate layer 10 can be formed from a mixed crystal of AlN, InN, and GaN.

### (Nitride Semiconductor Layer 4)

When tensile stress is applied to the nitride semiconductor layer 4 during the formation of the nitride semiconductor layer 4, concerns arise regarding crack generation and peeling. Consequently, the intermediate layer 10 is desirably designed so that compressive stress is applied to the nitride semiconductor layer 4. A method for applying the compressive stress by the intermediate layer 10 is not limited to a method described below, but it can be made by forming an intermediate layer having a lattice constant smaller than a lattice constant of the nitride semiconductor layer 4 and then growing the nitride semiconductor layer 4 by vapor phase growth directly on top of it to generate the compressive stress.

On the other hand, in a device process, it is concerned that increased warp may cause substrates falling due to adsorption failure or a decreased yield; therefore, it is desirable for the substrate warp after forming the nitride semiconductor layer 4 to be Warp < 50 µm and |Bow| ≤ 40 µm, if possible, Warp < 40 µm and |Bow| ≤ 30 µm. Thus, it is necessary to prevent the warp from increasing due to compressive stress to prevent cracking and peeling.

### (Device Layer 13)

The device layer 13 made of a thin nitride film is produced on the composite substrate 3 and the intermediate layer 10 by vapor phase growth, such as the MOVPE method, sputtering, or the like. The nitride usable is, for example, GaN, AlN, InN, AlGaN, InGaN, AlInN, AlScN, etc. The thin film of the nitride can be 1 to 10 µm and can be designed according to the device.

For example, in high-mobility transistors (HEMT) structure, the device layer 13 is configured to have the gallium nitride layer 11 and the electron supply layer 12 made of AlGaN formed on the gallium nitride layer 11. The device layer 13 is desirably a crystal having few crystal defects and few impurities such as carbon and oxygen for improving the device characteristics, and for example, this layer can be produced by the MOVPE method at 900°C to 1350°C.

The device layer 13 is also the nitride semiconductor layer 4.

### (Method for Manufacturing Nitride Semiconductor Epitaxial Wafer)

The inventive method for manufacturing a nitride semiconductor epitaxial wafer is a method for manufacturing a nitride semiconductor epitaxial wafer 100 which includes the composite substrate 3 having the ceramic-containing substrate 1 and the single crystal layer 2 bonded onto the ceramic-containing substrate 1, and the nitride semiconductor layer 4 epitaxially grown on the composite substrate 3 via the intermediate layer 10.

Hereinafter, the growing method for an epitaxial layer suitable for GaN HEMT is described.

The method for manufacturing a nitride semiconductor epitaxial wafer 100 can include, for example, the steps of providing the composite substrate, introducing the composite substrate, cleaning the composite substrate, forming the intermediate layer, epitaxially growing the gallium nitride layer, and growing the electron supply layer. However, the method of the present invention is not limited thereto.

### (Step of Providing Composite Substrate)

The step of providing a composite substrate is a step to provide the composite substrate 3.

The composite substrate 3 is a substrate used as an underlying substrate for epitaxially growing the nitride semiconductor layer 4.

The composite substrate 3 includes the ceramic-containing substrate 1 and the single crystal layer 2 bonded onto the ceramic-containing substrate 1; includes the ceramic-containing substrate 1 having a coefficient of thermal expansion within ±10% of a coefficient of thermal expansion of the nitride semiconductor layer 4; and have a shape of -150 < Bow (µm) ≤ 40, Warp (µm) < 150 and Warp (µm) < 90 - Bow (µm).

The composite substrate 3 is also the inventive composite substrate for a nitride semiconductor epitaxial wafer.

It is preferable that the ceramic-containing substrate 1 has a heat-resistant support substrate 7, which includes a ceramic core 5 and an encapsulating layer 6 covering the ceramic core 5, and a planarization layer 8 provided on the heat-resistant support substrate 7. It is preferable that the ceramic core 5 in which a polycrystalline AlN ceramic is a main component is used. Accordingly, a coefficient of thermal expansion of the ceramic-containing substrate 1 can be within ±10% of a coefficient of thermal expansion of the nitride semiconductor layer 4.

Note that the difference in the coefficient of thermal expansion within ±10% is the difference in a range of 800 to 1400°C (a temperature range during epitaxial growth).

It is preferable that the encapsulating layer 6 is formed from a component represented by SiOₓN_{y} (where x = 0 to 2, y = 0 to 1.5, x + y > 0). This can easily seal the ceramic core 5.

It is preferable that the planarization layer 8 is formed from any of SiOₓN_{y} (where x = 0 to 2, y = 0 to 1.5, x + y > 0) and aluminum arsenide. This can easily form a flat surface.

It is preferable that the single crystal layer 2 is formed from any of Si, SiGe, SiC, sapphire, GaN, AlGaN, and AlN.

### (Step of Introducing Composite Substrate)

The composite substrate 3 is cleaned with chemicals, then introduced into a reaction furnace of an MOVPE apparatus.

After introducing the composite substrate 3 into the reaction furnace, the furnace is filled with high-purity inert gas such as nitrogen to purge the inside of the furnace.

### (Step of Cleaning Composite Substrate)

The composite substrate 3 is heated in the reaction furnace and a surface of the substrate is subjected to cleaning.

A temperature for performing cleaning can be determined in a range of 1000°C to 1200°C on the surface temperature of the substrate, but a clean surface can be obtained by performing cleaning at 1050°C in particular.

The cleaning is performed after furnace pressure is reduced, and the furnace pressure can be determined to be between 200 mbar and 30 mbar. For example, the furnace pressure is set to 50 mbar to perform cleaning. The cleaning is performed for 10 minutes in a state where hydrogen or nitrogen is supplied in the furnace.

### (Step of Forming Intermediate Layer)

The step of forming the intermediate layer is a step of forming the intermediate layer 10 configured to apply compressive stress to the nitride semiconductor layer 4 on the single crystal layer 2 of the composite substrate 3.

In this step, AlN or AlₓGa₁₋ₓN (0 ≤ x < 1) is epitaxially grown on the single crystal layer 2 of the composite substrate 3 by introducing gas to be raw material Al, Ga, N sources at predetermined furnace pressure and substrate temperature.

Moreover, in this step, the growth is performed, for example, at the furnace pressure of 50 mbar and the substrate temperature of 1120°C. Trimethylaluminum (TMAl) is used as an Al source, trimethylgallium (TMGa) as a Ga source, and ammonia (NH₃) as an N source. In addition, in order to obtain a mixed crystal having a desired Al composition, a flow rate of raw material TMAl and TMGa is set to make the ratio of Al to Ga absorbed in a thin film to a preset ratio, considering a material efficiency of the raw material gas. In this step, the growth of AlN is performed with a flow rate of 0.24 (L/min) (240 sccm) for TMAl and 2 (L/min) (2000 sccm) for NH₃ under a standard condition. For example, hydrogen can be used as a carrier gas for TMAl, TMGa, and NH₃. These conditions are just an example and are not particularly limited thereto.

The nitride semiconductor epitaxial wafer 100, having a shape of Warp (µm) < 50 and |Bow (µm)| ≤ 40, is manufactured by adjusting a film thickness of the intermediate layer 10.

Adjusting the film thickness of the intermediate layer 10 refers to, for example,
(1) the intermediate layer 10 made of AlN and AlGaN is formed on the composite substrate 3 by the MOCVD method, in which an AlN layer is grown to 250 nm, and an AlGaN layer is formed to 450 nm such that Al composition decreases from a substrate side toward a surface side,
(2) the intermediate layer 10 made of AlN and AlGaN is formed on the composite substrate 3 by the MOCVD method, in which an AlN layer is grown to 250 nm, and an AlGaN layer is formed to 90 nm such that Al composition decreases from a substrate side toward a surface side,
(3) the intermediate layer 10 made of AlN and AlGaN is formed by the MOCVD method, in which an AlN layer is grown to 250 nm, and an AlGaN layer is formed to 150 nm such that Al composition decreases from a substrate side toward a surface side, etc.

The method of reducing the Al composition may be either continuous or discontinuous, and it is also acceptable to have areas where the Al composition is locally high, as long as that in the overall layer decreases towards the surface side and the compressive stress can be applied to the nitride semiconductor layer 4.

The intermediate layer 10 is preferably formed from a mixed crystal of AlN, InN, and GaN.

### (Step of Epitaxially Growing Gallium Nitride Layer)

The step of epitaxially growing a gallium nitride layer is a step of epitaxially growing the gallium nitride layer 11 on the intermediate layer 10.

In this step, the gallium nitride layer 11 made of GaN or AlₓGa₁₋ₓN (0 < x ≤ 1) is epitaxially grown on the intermediate layer 10 by introducing gas to be raw material Ga and N sources at a predetermined furnace pressure and a substrate temperature.

Moreover, in this step, the growth is performed, for example, at the furnace pressure of 200 mbar and the substrate temperature of 1120°C. Trimethylgallium (TMGa) is used as a Ga source, and ammonia (NH₃) as an N source. In addition, in order to obtain a mixed crystal having a desired Al composition, a flow rate of raw materials TMAl and TMGa is set to make the ratio of Al to Ga absorbed in a thin film to a preset ratio, considering a material efficiency of the raw material gas. For example, hydrogen can be used as a carrier gas for TMAl, TMGa, and NH₃. These conditions are just an example and are not particularly limited.

### (Step of Growing Electron Supply Layer)

In this step, the electron supply layer 12 made of AlₓGa₁₋ₓN (0 < x ≤ 1) is epitaxially grown on the gallium nitride layer 11 by introducing a gas to be raw material Al, Ga, and N sources at a predetermined furnace pressure and substrate temperature.

In this step, the growth is performed, for example, at the furnace pressure of 150 mbar and the substrate temperature of 1120°C. Trimethylaluminum (TMAl) is used as an Al source, trimethylgallium (TMGa) as a Ga source, and ammonia (NH₃) as an N source. In addition, in order to obtain a mixed crystal having a desired Al composition, a flow rate of raw material TMAl and TMGa is set to make the ratio of Al to Ga absorbed in a thin film to a preset ratio, considering a material efficiency of the raw material gas. For example, hydrogen can be used as a carrier gas for TMAl, TMGa, and NH₃. These conditions are just an example and are not particularly limited thereto.

### (Explanation of Criteria for Warp and Bow)

The composite substrates 3 purchased are not all flat. When GaN is stacked on such composite substrate 3, GaN is subjected to various stresses generated by difference in shapes and materials of the substrate, and warp of the substrate after epitaxial formation is determined. In addition, since it is difficult to directly grow high-quality GaN on Si, an Al-containing nitride layer in which a base layer has excellent function is provided as the intermediate layer 10. It is found that the stress applied to a gallium nitride (GaN) layer 11 from the substrate can be adjusted due to the thickness and compositional structure of the intermediate layer 10, thereby enabling control of the overall warp. When tensile stress is applied to GaN in the intermediate layer 10, the GaN epitaxial layer is expected to be warped in the negative direction; however, it is found that the epitaxial layer is peeled off when the tensile stress is applied to the GaN epitaxial layer. Therefore, it is found that it is desirable to apply the compressive stress to GaN in intermediate layer 10, i.e., to apply the stress in a direction where the positive warp is generated.

In this way, the warp of the substrate after epitaxial formation in which the intermediate layer 10 with the compressive stress to GaN is provided results in this positive warp being added to an original warp of the composite substrate 3. Consequently, when the warp is negative at a stage of the composite substrate 3, an absolute value of the warp after the epitaxial formation can be reduced by offsetting with applying a positive compressive stress during the epitaxial formation. However, when the positive warp exceeds 40 µm, which is an upper limit of a target value after the epitaxial formation at the stage of the composite substrate 3, the only way to make the warp after the epitaxial formation 40 µm or less is to provide the intermediate layer 10 having the tensile stress, but this leads to generation of peeling.

Since an amount of the compressive stress can be controlled by the thickness or the like, the intermediate layer 10 with a less compressive stress may be adopted when the composite substrate 3 is more warped in the positive direction.

Moreover, with regard to the Warp of the composite substrate 3, it is possible to correct the warp to the positive side until the Bow of an epitaxial layer substrate (substrate 100 after forming nitride semiconductor layer 4) reaches 40 µm by applying the compressive strain using the intermediate layer 10. Therefore, it is considered that it is possible to correct (40 - Bow of composite substrate) µm at maximum in the epitaxial step (intermediate layer and device layer). Accordingly, to realize a Warp of less than 50 µm for the epitaxial substrate, the Warp for the composite substrate is considered to be 50 + (40 - Bow) µm as the maximum amount of the warp. On the other hand, when an amount of displacement during growth is large, a film-thickness distribution is changed due to shape change of the wafer, thus, it is desirable to have both Bow and Warp to be less than 150 µm.

A paragraph described above describes a basis for the value of the Warp of the composite substrate 3. The first half is a description regarding 90 - Bow. Although it is desirable for the epitaxial step to generate the positive warp, when a variation of the warp in the epitaxial step is defined as +Δ, +Δ can be allowed up to (40 - composite substrate Bow). Specifically, the upper limit of an intended positive warp after epitaxial growth is Bow ≤ 40; thus, for example, when the composite substrate Bow = 40, +Δ = 40 - 40 = 0, resulting in no room for a positive warping in the step after the intermediate layer 10; when Bow thereof = 39, +Δ = 1, resulting in a room for warping of 1 µm only. It is then understood that this room +Δ is added to the Warp upper limit of 50 to reach the upper limit of Warp < (90 - composite substrate Bow).

Thus, the first half of the paragraph describes that the composite substrate 3 has already been warped to the positive side such that +Δ added in the epitaxial step is determined by the upper limit being Bow = +40 after epitaxial growth. In the last sentence, however, it is mentioned that excessive +Δ is unfavorable, leading to an acceptable lower limit of the negative side of the composite substrate 3. When the composite substrate 3 is warped to the negative side, naturally, a room to the positive upper limit after the epitaxial growth is increased. For example, when the composite substrate 3 has Bow = -150, the substrate can be warped by +110 in the epitaxial step to reach the epitaxial target lower limit of -40, or can be warped by +190 to reach the epitaxial upper limit of +40. Conversely, when it is acceptable to warp by +190 or more in the epitaxial step, composite substrate 3 can tolerate a larger negative value, but when the +Δ is increased to that extent, a problem arises.

A method for controlling a shape of the composite substrate 3 is not limited to methods described below, but production can be performed by a method for subjecting the ceramic core 5 to polish processing to make a concave shape, a method for warping by forming a SiO₂ film on one surface, and a method for selecting a concave-shaped ceramic core 5.

For example, the ceramic core 5 is processed by polish processing to achieve Bow - 50 µm. The method for processing into the concave shape is not limited to the following, but, for example, the ceramic core 5 can be produced by making a shape of a polishing turntable in contact with the surface side convex shape. Subsequently, the encapsulating layer 6 is formed to cover the ceramic core 5 to a thickness of 0.05 to 1.5 µm to produce the heat-resistant support substrate 7. The film-forming method is not limited to the following but the growth may be performed by the LPCVD method, for example.

Subsequently, the planarization layer 8 of 0.2 to 3 µm is formed on an upper surface of the heat-resistant support substrate 7 to produce the ceramic-containing substrate 1. The film-forming of the planarization layer 8 is not limited to the following, but the planarization layer 8 can be formed by a plasma CVD, LPCVD, reduced pressure MOCVD method. Moreover, a stress adjustment layer may be formed on a lower surface of the heat-resistant support substrate 7 to adjust the warp. A composite substrate can be obtained by transferring the single crystal layer 2 to the ceramic-containing substrate 1.

The planarization layer 8 is formed only on the front surface side of the substrate 7, which causes the composite substrate 3 to generate the warp. However, by processing the ceramic core 5, the Bow of the composite substrate 3 can be controlled in a range of -150 to 40 µm, with Warp < 150 µm and Warp < 90 - Bow (µm). Alternatively, the stress adjustment layer can be formed on a back surface of the resistant support substrate 7 at the same time with the formation of the planarization layer 8 or after the formation thereof to control the Bow of the composite substrate 3 in a range of -150 to 40 µm, with Warp < 150 µm and Warp < 90-Bow (µm).

As described above, by using the inventive method for manufacturing a nitride semiconductor epitaxial wafer, an inexpensive GaN epitaxial substrate having Warp (µm) < 50 and |Bow (µm)| ≤ 40, without cracks or epitaxial layer peeling, can be obtained at a high yield.

### EXAMPLE

Hereinafter, the present invention will be specifically described with reference to Examples. However, the present invention is not limited thereto.

### [Example 1]

A ceramic core made of AlN ceramic (resistivity of 10¹⁴ Qcm or more) was provided.

A shape of the ceramic core was processed by mechanical polishing to form a concave shape.

As a result of measuring a processed substrate with a shape measuring instrument (OPTM manufactured by OTSUKA ELECTRONICS CO.,LTD), Bow was -189 µm and Warp was 189 µm.

Subsequently, an encapsulating layer made of silicon nitride and a planarization layer made of silicon oxide were grown to 2 µm to produce a ceramic-containing substrate.

Next, a silicon single crystal film of 300 nm was bonded to the ceramic-containing substrate to produce a composite substrate.

A silicon single crystal film was formed by providing an Si <111> substrate, forming a frangible layer by ion implantation, and transferring the substrate on the ceramic-containing substrate.

On the composite substrate produced in this way, an intermediate layer made of AlN and AlGaN was formed using an MOCVD method.

The AlN layer was grown to 250 nm, and the AlGaN layer was formed such that Al composition decreases from the substrate side to a front surface side, resulting in the AlGaN layer of 450 nm.

After forming the intermediate layer, a 5750 nm gallium nitride layer, which serves as a device layer, and a 25 nm electron supply layer made of AlGaN were grown to produce a nitride semiconductor epitaxial wafer.

Regarding the thickness of a gallium nitride layer, 5750 nm was adopted as the thickness that can obtain sufficient dislocation density and withstand voltage to produce a GaN HEMT device.

In addition, even when the thickness of the gallium nitride layer was further increased for device design convenience, stress caused by a difference in lattice constant at an interface with the intermediate layer was relaxed, thus, the warp was not significantly affected.

### [Example 2]

A composite substrate was produced with the same material and production conditions as in Example 1, except that Bow and Warp, after processing a ceramic core, were -1 µm and 47 µm, respectively.

On the composite substrate produced in this way, an intermediate layer made of AlN and AlGaN was formed using the MOCVD method.

The AlN layer was grown to 250 nm, and the AlGaN layer was formed such that Al composition decreases from the substrate side to a front surface side, resulting in the AlGaN layer of 90 nm.

After forming the intermediate layer, a 5750 nm gallium nitride layer, which serves as a device layer, and a 25 nm electron supply layer made of AlGaN were grown to produce a nitride semiconductor epitaxial wafer (the epitaxial step is the same as in Example 1, except the intermediate layer).

### [Example 3]

A nitride semiconductor epitaxial wafer was produced with the same material and production conditions as those of a composite substrate, an intermediate layer, and a nitride semiconductor layer as in Example 1, except that Bow and Warp, after processing a ceramic core, were -100 µm and 189 µm, respectively.

### [Example 4]

A composite substrate was produced with the same material and production conditions as in Example 1, except that Bow and Warp, after processing a ceramic core, were -30 µm and 49 µm, respectively.

On the composite substrate produced in this way, an intermediate layer made of AlN and AlGaN was formed using the MOCVD method.

The AlN layer was grown to 250 nm, and the AlGaN layer was formed such that Al composition decreases from the substrate side to a front surface side, resulting in the AlGaN of 150 nm.

After forming the intermediate layer, a 5750 nm gallium nitride layer, which serves as a device layer, and a 25 nm electron supply layer made of AlGaN were grown to produce a nitride semiconductor epitaxial wafer.

### [Comparative Example 1]

A nitride semiconductor epitaxial wafer was produced with the same material and production conditions as those of a composite substrate, an intermediate layer, and a nitride semiconductor layer as in Example 1, except that Bow and Warp, after processing a ceramic core, were -191 µm and 191 µm, respectively.

### [Comparative Example 2]

A nitride semiconductor epitaxial wafer was produced with the same material and production conditions as those of a composite substrate, an intermediate layer, and a nitride semiconductor layer as in Example 2, except that Bow and Warp, after processing a ceramic core, were 1 µm and 49 µm, respectively.

### [Comparative Example 3]

A nitride semiconductor epitaxial wafer was produced with the same material and production conditions as those of a composite substrate, an intermediate layer, and a nitride semiconductor layer as in Example 1, except that Bow and Warp, after processing a ceramic core, were -100 µm and 190 µm, respectively.

### [Comparative Example 4]

A nitride semiconductor epitaxial wafer was produced with the same material and production conditions as those of a composite substrate, an intermediate layer, and a nitride semiconductor layer as in Example 4, except that Bow and Warp, after processing a ceramic core, were -30 µm and 50 µm, respectively.

### [Comparative Example 5]

A composite substrate was produced with the same material and production conditions as in Example 1, except that Bow and Warp, after processing a ceramic core, were 0 µm and 49 µm, respectively.

On the composite substrate produced in this way, an intermediate layer made of AlN, GaN, and AlGaN was formed using an MOCVD method.

In Comparative Example 5, the AlN layer was grown to 250 nm, and the AlGaN layer was grown to the 180 nm AlGaN layer with an Al composition of 50% and to the 800nm AlGaN layer with an Al composition of 60% such that Al composition increases from the substrate side to a front surface side.

After forming the intermediate layer, a 5750 nm gallium nitride layer, which serves as a device layer, and a 25 nm electron supply layer made of AlGaN were grown to produce a nitride semiconductor epitaxial wafer.

The warps (Bow, Warp) of the wafers produced in Examples and Comparative Examples described above were measured using a shape measuring instrument (OPTM manufactured by OTSUKA ELECTRONICS CO.,LTD). In addition, peeling at an outer periphery portion was observed using visual inspection and a stereomicroscope.
Table 1 shows the results of warp measurements and the results of peeling observation at the outer periphery portion.

**[Table 1]**

| | Ceramic Core | | Composite Substrate | | Nitride Semiconductor Epitaxial Wafer | | Warp after Epitaxial Growth | Peeling | Pass/Fail of Wafer |
|---|---|---|---|---|---|---|---|---|---|
| | Bow | Warp | Bow | Warp | Bow | Warp | | | |
| Example 1 | -189 | 189 | -149 | 149 | -39 | 39 | Good | Absent | Pass |
| Comparative Example 1 | -191 | 191 | -150 | 151 | -41 | 41 | Poor | Absent | Fail |
| Example 2 | -1 | 47 | 39 | 49 | 39 | 49 | Good | Absent | Pass |
| Comparative Example 2 | 1 | 49 | 41 | 48 | 41 | 48 | Poor | Absent | Fail |
| Example 3 | -100 | 189 | -61 | 149 | 39 | 49 | Good | Absent | Pass |
| Comparative Example 3 | -100 | 190 | -62 | 150 | 39 | 53 | Poor | Absent | Fail |
| Example 4 | -30 | 49 | 10 | 78 | 39 | 49 | Good | Absent | Pass |
| Comparative Example 4 | -30 | 50 | 11 | 79 | 39 | 50 | Poor | Absent | Fail |
| Comparative Example 5 | 0 | 49 | 41 | 49 | 30 | 39 | Good | Present | Fail |

In Examples 1 to 4, the productions were performed according to the method of the present invention, and the warp after the growth of the nitride semiconductor layer was |Bow| ≤ 40 µm and Warp < 50 µm. In addition, as for the results of observation of the outer periphery potion, no peeling was observed.

In Comparative Examples 1 to 4, warp after the growth of the nitride semiconductor layer increased during an epitaxial step, causing a warp failure.

Moreover, in Comparative Example 5, tensile stress was applied due to stress during epitaxial growth, and the warp was |Bow| ≤ 40 µm and Warp < 50 µm; however, the epitaxial layer was peeled from the outer periphery portion, causing a failure.

Furthermore, in Comparative Examples 4 and 5, the composite substrate did not have a shape where Warp (µm) < 90 - Bow (µm).

As described above, according to Examples of the present invention, the epitaxial substrates were successfully manufactured with a small warp without cracks or peeling.

The present description includes the following embodiments.
[1]: A method for manufacturing a nitride semiconductor epitaxial wafer that comprises a composite substrate having a ceramic-containing substrate and a single crystal layer bonded onto the ceramic-containing substrate, and a nitride semiconductor layer epitaxially grown on the composite substrate, the method comprising the steps of:
   providing the composite substrate comprising the ceramic-containing substrate having a coefficient of thermal expansion within ±10% of a coefficient of thermal expansion of the nitride semiconductor layer, and having a shape of -150 < Bow (µm) ≤ 40, Warp (µm) < 150 and Warp (µm) < 90 - Bow (µm);
   forming an intermediate layer configured to apply compressive stress to the nitride semiconductor layer on the single crystal layer of the composite substrate; and
   epitaxially growing the nitride semiconductor layer on the intermediate layer, wherein
   the nitride semiconductor epitaxial wafer having a shape of Warp (µm) < 50 and |Bow (µm)| ≤ 40 is manufactured by adjusting a film thickness of the intermediate layer.
[2]: The method for manufacturing a nitride semiconductor epitaxial wafer according to the above [1], wherein
   the ceramic-containing substrate has a heat-resistant support substrate having a ceramic core and an encapsulating layer covering the ceramic core, and a planarization layer provided on the heat-resistant support substrate.
[3]: The method for manufacturing a nitride semiconductor epitaxial wafer according to the above [2], wherein
   the ceramic core in which a polycrystalline AlN ceramic is a main component is used.
[4]: The method for manufacturing a nitride semiconductor epitaxial wafer according to the above [2] or [3], wherein
   the encapsulating layer is formed from a component represented by SiOₓN_{y} (where x = 0 to 2, y = 0 to 1.5, x + y > 0).
[5]: The method for manufacturing a nitride semiconductor epitaxial wafer according to any of the above [2] to [4], wherein
   the planarization layer is formed from any of SiOₓN_{y} (where x = 0 to 2, y = 0 to 1.5, x + y > 0) and aluminum arsenide.
[6]: The method for manufacturing a nitride semiconductor epitaxial wafer according to any of the above [1] to [5], wherein
   the single crystal layer is formed from any of Si, SiGe, SiC, sapphire, GaN, AlGaN, and AlN.
[7]: The method for manufacturing a nitride semiconductor epitaxial wafer according to any of the above [1] to [6], wherein
   the intermediate layer is formed from a mixed crystal of AlN, InN, and GaN.
[8]: A composite substrate for a nitride semiconductor epitaxial wafer in which the composite substrate is used as an underlying substrate for epitaxially growing a nitride semiconductor layer, the composite substrate comprising:
   a ceramic-containing substrate; and
   a single crystal layer bonded onto the ceramic-containing substrate, wherein
   the ceramic-containing substrate has a coefficient of thermal expansion within ±10% of a coefficient of thermal expansion of the nitride semiconductor layer, and has a shape of -150 < Bow (µm) ≤ 40, Warp (µm) < 150 and Warp (µm) < 90 - Bow (µm).

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a nitride semiconductor epitaxial wafer that comprises a composite substrate having a ceramic-containing substrate and a single crystal layer bonded onto the ceramic-containing substrate, and a nitride semiconductor layer epitaxially grown on the composite substrate, the method comprising the steps of:
providing the composite substrate comprising the ceramic-containing substrate having a coefficient of thermal expansion within ±10% of a coefficient of thermal expansion of the nitride semiconductor layer, and having a shape of -150 < Bow (µm) ≤ 40, Warp (µm) < 150 and Warp (µm) < 90 - Bow (µm);
forming an intermediate layer configured to apply compressive stress to the nitride semiconductor layer on the single crystal layer of the composite substrate; and
epitaxially growing the nitride semiconductor layer on the intermediate layer, wherein
the nitride semiconductor epitaxial wafer having a shape of Warp (µm) < 50 and |Bow (µm)| ≤ 40 is manufactured by adjusting a film thickness of the intermediate layer.

2. The method for manufacturing a nitride semiconductor epitaxial wafer according to claim 1, wherein
the ceramic-containing substrate has a heat-resistant support substrate having a ceramic core and an encapsulating layer covering the ceramic core, and a planarization layer provided on the heat-resistant support substrate.

3. The method for manufacturing a nitride semiconductor epitaxial wafer according to claim 2, wherein
the ceramic core in which a polycrystalline AlN ceramic is a main component is used.

4. The method for manufacturing a nitride semiconductor epitaxial wafer according to claim 2, wherein
the encapsulating layer is formed from a component represented by SiOₓN_{y} (where x = 0 to 2, y = 0 to 1.5, x + y > 0).

5. The method for manufacturing a nitride semiconductor epitaxial wafer according to claim 2, wherein
the planarization layer is formed from any of SiOₓN_{y} (where x = 0 to 2, y = 0 to 1.5, x + y > 0) and aluminum arsenide.

6. The method for manufacturing a nitride semiconductor epitaxial wafer according to claim 1, wherein
the single crystal layer is formed from any of Si, SiGe, SiC, sapphire, GaN, AlGaN, and AlN.

7. The method for manufacturing a nitride semiconductor epitaxial wafer according to claim 1, wherein
the intermediate layer is formed from a mixed crystal of AlN, InN, and GaN.

8. A composite substrate for a nitride semiconductor epitaxial wafer in which the composite substrate is used as an underlying substrate for epitaxially growing a nitride semiconductor layer, the composite substrate comprising:
a ceramic-containing substrate; and
a single crystal layer bonded onto the ceramic-containing substrate, wherein
the ceramic-containing substrate has a coefficient of thermal expansion within ±10% of a coefficient of thermal expansion of the nitride semiconductor layer, and has a shape of -150 < Bow (µm) ≤ 40, Warp (µm) < 150 and Warp (µm) < 90 - Bow (µm).
